# EUROPEAN PATENT SPECIFICATION

(11) **EP 4 053 213 B1**
(45) Date of publication and mention of the grant of the patent: **10.04.2024**
(21) Application number: 20881535.7
(22) Date of filing: 30.10.2020
(51) Int. Cl.: C08L 63/00, C08K 3/013, C09K 5/14, H01L 23/373

(54) **RESIN COMPOSITION, CURED PRODUCT, COMPOSITE MOLDED BODY AND SEMICONDUCTOR DEVICE**
HARZZUSAMMENSETZUNG, GEHÄRTETES PRODUKT, VERBUNDFORMKÖRPER UND HALBLEITERVORRICHTUNG
COMPOSITION DE RÉSINE, PRODUIT DURCI, CORPS MOULÉ COMPOSITE ET DISPOSITIF SEMI-CONDUCTEUR

(30) Priority: 30.10.2019 JP 2019197273
(43) Date of publication of application: 07.09.2022
(73) Proprietor: Mitsubishi Chemical Corporation, Chiyoda-ku Tokyo 100-8251 (JP)
(72) Inventor: KIMURA Akinori, Tokyo 100-8251 (JP); TANAKA Toshiyuki, Tokyo 100-8251 (JP); DAO Thi Kim Phuong, Tokyo 100-8251 (JP); KATOU Tomoki, Tokyo 100-8251 (JP)
(74) Representative: Hoffmann Eitle
(86) International application number: PCT/JP2020/040787
(87) International publication number: WO 2021/085593

(56) References cited:
- WO-A1-2018/139645
- WO-A1-2018/235918
- JP-A- H01 115 940
- JP-A- 2002 249 727
- JP-A- 2017 188 306
- JP-A- 2019 119 883
- JP-A- 2020 158 694
- KR-A- 20190 057 400

## Description

### [Technical Field]

The present invention relates to a resin composition, a cured product, a composite molded product, and a semiconductor device.

Priority is claimed on Japanese Patent Application No. 2019-197273, filed October 30, 2019.

### [Background Art]

Power semiconductor devices are used in various fields such as railways, automobiles, and general household appliances. In recent years, in power semiconductor devices, in order to further reduce size, reduce cost, improve efficiency, and the like, power semiconductors of the related art formed of Si have shifted to power semiconductors formed of SiC, AlN, GaN, and the like.

A power semiconductor device is generally used as a power semiconductor module in which a plurality of semiconductor devices are arranged on a common heat sink and packaged.

Various problems have been pointed out regarding the practical use of such power semiconductor devices, one of them being the heat dissipation of heat generated from the device. Generally, in the power semiconductor device, it is possible to increase an output and a density by operating the power semiconductor device at a high temperature. Therefore, insufficient heat dissipation affects reliability of the power semiconductor device. For example, there is a concern that heat generation accompanied with device switching reduces reliability.

Particularly in the fields of electricity and electronics in recent years, the density of an integrated circuit has been further increased, and how to dissipate the heat generated due to such an increase in density is an urgent issue.

As one method for solving this problem, a ceramic substrate having high thermal conductivity such as an alumina substrate or an aluminum nitride substrate is used as a heat dissipation substrate on which a power semiconductor device is mounted. However, the ceramic substrate has drawbacks such as being easily broken by an impact, being difficult to make into a thin film, and being difficult to reduce the size thereof.

Therefore, a heat-dissipating resin sheet using a thermosetting resin such as an epoxy resin having high thermal conductivity and an inorganic filler-containing resin composition including an inorganic filler having high thermal conductivity has been proposed (for example, Patent Document 1). Patent Document 1 discloses a heat-dissipating resin sheet including a resin and a boron nitride filler, in which a content of the boron nitride filler is 30 vol% or more and 60 vol% or less, and a Tg of the resin is 60°C or less.

Patent Document 2 describes a resin material and a laminate comprising a thermal conductor, an insulating layer laminated on one face of the thermal conductor and a conductive layer laminated on a face opposite to the thermal conductor of the insulating layer, the insulating layer being formed of the resin material. The resin material comprises first boron nitride aggregate particles; and a binder resin, the first boron nitride aggregate particles having a porosity of less than 30%, the second boron nitride aggregate particles having a porosity of 30% or more and each of an aspect ratio of primary particles constituting the first boron nitride aggregate particles, and an aspect ratio of primary particles constituting the second boron nitride aggregate particles being 7 or less.

Patent Document 3 describes a resin material and a laminate comprising a thermal conductor, an insulating layer laminated on one surface of the thermal conductor and a conductive layer laminated on one surface of the insulating layer opposite to the thermal conductor, the insulating layer comprising the resin material. The resin material comprises first inorganic particles having an average aspect ratio of 2 or less; second inorganic particles having an average aspect ratio of more than 2; and a binder resin, an absolute value of a difference between an average particle diameter of the first inorganic particles and an average major diameter of the second inorganic particles being 10 µm or less, the average particle diameter of the first inorganic particles being 1 µm or more and less than 20 µm, the average major diameter of the second inorganic particles being 2 µm or more, the content of the second inorganic particles being more than 40% by volume relative to 100% by volume of sum of the first inorganic particles and the second inorganic particles.

### [Citation List]

### [Patent Document]

[Patent Document 1]
   Japanese Unexamined Patent Application First Publication No. 2017-36415
[Patent Document 2]
   WO 2018/139645 A1
[Patent Document 3]
   WO 2018/235918 A1

### [Summary of Invention]

### [Technical Problem]

However, a heat-dissipating resin sheet using an inorganic filler-containing resin composition of the related art has the following problems (1) to (3) when it is applied to a power semiconductor device.

(1) When incorporating the heat-dissipating resin sheet into the power semiconductor device, a molding pressurization step is performed in which a pressure is applied to the resin composition to adhere the resin composition to a metal to form a cured product. However, when the resin composition is stored after being produced and the molding pressurization step is performed after the storage period has elapsed, the longer the storage period, the more a curing reaction of a thermosetting resin in the resin composition progresses, and the original performance may not be exhibited in the molding step. For example, if the curing reaction of the thermosetting resin progresses too much, a degree of adhesion of the heat-dissipating resin sheet to the metal decreases.
(2) In addition, as a method for improving the thermal conductivity of the heat-dissipating resin sheet in a thickness direction, the pressure can be applied to the resin composition in the molding pressurization step to adhere inorganic fillers in the resin composition to each other. However, if a curing reaction of the thermosetting resin progresses too much during storage of the resin composition, it is difficult for the inorganic fillers to adhere to each other even if the pressure is applied in the molding pressurization step. As a result, it is difficult to sufficiently improve the thermal conductivity of the heat-dissipating resin sheet.

In order to exhibit high thermal conductivity, for example, an aggregated inorganic filler whose morphology is easily deformed by the molding pressurization step can also be used. However, if the curing reaction of the thermosetting resin progresses too much during the storage of the resin composition, the deformation of the aggregated inorganic filler is also hindered, so that the effect of improving the thermal conductivity by improving the adhesion between the inorganic fillers is also hindered.

(3) Further, as a method for improving an insulating property of the heat-dissipating resin sheet and adhesion to a metal, pressure is applied to the resin composition in the molding pressurization step to remove voids in the resin composition and an interface between the resin composition and the metal. However, if the curing reaction of the thermosetting resin progresses too much during the storage of the resin composition, it is also difficult to remove the voids in the molding pressurization step. When the voids are not sufficiently removed, the cured product and the metal may be peeled off at the interface thereof during heating by a reflow furnace in a manufacturing step of the power semiconductor module.

The present invention provides a resin composition which has excellent thermal conductivity and adhesion to a metal and with which a cured product that does not easily peel off at an interface when it is compounded with a metal is obtained; a resin cured product which has excellent thermal conductivity and adhesion to a metal and which does not easily peel off at an interface when it is compounded with a metal; a composite molded product which has excellent thermal conductivity and adhesion between a resin cured product and a metal and which does not easily peel off at an interface; and a semiconductor device which has excellent heat dissipation property and adhesion between a resin cured product and a metal and which does not easily peel off at an interface.

### [Solution to Problem]

A resin composition containing an inorganic filler, a thermosetting resin, and a thermosetting catalyst, in which the inorganic filler contains an aggregated inorganic filler, the thermosetting resin contains an epoxy resin, the resin composition contains two or more kinds of thermosetting catalysts having a melting point of 100°C or higher, and two or more kinds of the thermosetting catalysts have a structure derived from imidazole.

Further embodiments of the resin composition, a resin cured product formed of the resin composition, a composite molded product having the resin cured product and a metal, and a semiconductor device including the composite molded product are described below and in the appended claims.

### [Advantageous Effects of Invention]

According to the resin composition of the present invention, a cured product which has excellent thermal conductivity and adhesion to a metal and which does not easily peel off at an interface when it is compounded with a metal is obtained.

The resin cured product of the present invention has excellent thermal conductivity and adhesion to a metal and does not easily peel off at an interface when it is compounded with a metal.

The composite molded product of the present invention has excellent thermal conductivity and adhesion between a resin cured product and a metal, and does not easily peel off at an interface thereof.

The semiconductor device of the present invention has excellent heat dissipation property and adhesion between a resin cured product and a metal and does not easily peel off at an interface thereof.

### [Description of Embodiments]

Hereinafter, embodiments of the present invention will be described in detail, but the present invention is not limited to the following embodiments, and can be variously modified and implemented within the scope of the gist thereof.

### <Resin Composition>

The resin composition of the present invention contains an aggregated inorganic filler, a thermosetting resin, and a thermosetting catalyst. The resin composition of the present invention is a composition in a state before curing. For example, compositions in a state before curing of a slurry-like resin composition to be subjected to a coating step which will be described later, a sheet that has undergone the coating step, a sheet that has undergone a step such as coating and drying, and the like are all treated as the resin composition.

Meanwhile, the resin cured product using the resin composition of the present invention has an exothermic peak of 10 J/g or less obtained when a temperature is raised from 40°C to 250°C at 10°C/min by differential scanning calorimetry (DSC).

In the resin composition of the present invention, the thermosetting resin contains an epoxy resin, and the thermosetting catalyst contains two or more kinds of thermosetting catalysts having a melting point of 100°C or higher. Accordingly, it is possible to reduce a reaction rate of the thermosetting resin and suppress excessive progress of a curing reaction.

Here, it is also conceivable to reduce the amount of the curing catalyst in order to reduce the reaction rate and suppress the progress of the curing reaction. However, if the amount of the curing catalyst is reduced, the curing reaction of the thermosetting resin is stopped in the middle, or the progress of the curing reaction becomes insufficient. As a result, an elastic modulus of the cured product is decreased, and the thermal conductivity, strength of the cured product, dielectric characteristics, heat resistance, and the like are reduced.

Therefore, in the present invention, by combining two or more kinds of thermosetting catalysts having different melting points of 100°C or higher, the reaction rate of the thermosetting resin during storage can be reduced and the curing reaction can sufficiently progress when curing is performed in a molding pressurization step and the like. Such a resin composition can be suitably used as a material of a heat dissipation sheet for a power semiconductor device, and a power semiconductor module having high reliability can be realized.

### (Inorganic Filler)

The resin composition of the present invention contains an inorganic filler. The inorganic filler contains an aggregated inorganic filler. The inorganic filler may further contain a non-aggregated inorganic filler, in addition to the aggregated inorganic filler. However, in order to improve the thermal conductivity of the resin cured product of the present invention and control a coefficient of linear expansion, it is preferable to increase a proportion of the aggregated inorganic filler in the inorganic filler.

Since the resin composition of the present invention contains the aggregated inorganic filler in the inorganic filler, the aggregated inorganic fillers are deformed by contacting each other in the molding pressurization step, and are easily surface-contacted. Therefore, more heat conduction paths are formed, and the thermal conductivity of the cured product tends to increase. The aggregated form of the aggregated inorganic filler can be checked by a scanning electron microscope (SEM).

In the resin composition of the present invention, the non-aggregated inorganic filler and an organic filler may be used in combination, in addition to the inorganic filler.

As the aggregated inorganic filler, an electrically insulating inorganic compound is preferable. For example, a filler composed of at least one or more kinds of particles selected from the group consisting of metal carbide, metal oxide, and metal nitride is an exemplary example.

For metal carbide, silicon carbide, titanium carbide, tungsten carbide, and the like are exemplary examples.

For metal oxide, magnesium oxide, aluminum oxide, silicon oxide, calcium oxide, zinc oxide, yttrium oxide, zirconium oxide, cerium oxide, ytterbium oxide, sialon (ceramics composed of silicon, aluminum, oxygen, and nitrogen) are exemplary examples.

For metal nitride, boron nitride, aluminum nitride, silicon nitride, and the like are exemplary examples.

Among these, metal oxide and metal nitride are preferable because the resin cured product has excellent electrical insulating property.

Since power semiconductors are required to have insulating property, the aggregated inorganic filler is preferably formed of an inorganic compound having excellent insulating property. Specifically, an inorganic compound having a volume resistivity of 1 × 10¹³ Ω · cm or more is preferable, and an inorganic compound having a volume resistivity of 1 × 10¹⁴ Ω · cm or more is more preferable.

For the inorganic compound having excellent insulating property, alumina (Al₂O₃, volume resistivity: 1 × 10¹⁴ Ω · cm), aluminum nitride (AlN, volume resistivity: 1 × 10¹⁴ Ω · cm), boron nitride (BN, volume resistivity: 1 × 10¹⁴ S2 · cm), silicon nitride (Si₃N₄, volume resistivity 1 × 10¹⁴ Ω · cm), silica (SiO₂, volume resistivity 1 × 10¹⁴Ω · cm), and the like are exemplary examples.

Among these, alumina, aluminum nitride, boron nitride, and silica are preferable, and alumina and boron nitride are more preferable.

The aggregated inorganic filler may be surface-treated with a surface treatment agent. As the surface treatment agent, a well-known surface treatment agent can be used.

The aggregated inorganic filler may be used alone as one kind thereof or may be used in combination of two or more optional kinds thereof at an optional ratio.

A method and a degree of aggregation of the aggregated inorganic filler are not particularly limited. However, it is preferable to use the following boron nitride aggregated particles as the aggregated inorganic filler. In addition, a filler having a different shape and type from those of the boron nitride aggregated particles may be used in combination.

### [Boron Nitride Aggregated Particles]

Boron nitride has high thermal conductivity but is scaly, and has heat conduction in a plane direction but high heat resistance in a direction perpendicular to the plane. It is preferable to use aggregated particles in which scales are collected and aggregated into a spherical shape in order to improve handleability.

The boron nitride aggregated particles preferably have a card-house structure.

The "card-house structure" is, for example, described in Ceramics 43 No. 2 (published by The Ceramic Society of Japan in 2008), and is a structure in which plate-shaped particles are not oriented and are intricately laminated.

More specifically, the boron nitride aggregated particles having a card-house structure are an aggregate of boron nitride primary particles, and are boron nitride aggregated particles having a structure in which a plane portion and an end surface portion of the primary particle are in contact with each other to form, for example, a T-shaped associated body.

As the boron nitride aggregated particles used in the present invention, the boron nitride aggregated particles having the card-house structure are particularly preferable, and by using the boron nitride aggregated particles having the card-house structure, the thermal conductivity can be further increased.

A new Mohs hardness of the boron nitride aggregated particles is not particularly limited, but is preferably 5 or less. When the new Mohs hardness is 5 or less, the particles dispersed in the resin composition are likely to come into surface contact with each other, a heat conduction path between the particles is formed, and the heat conduction of the resin cured product tends to be improved. A lower limit value of the new Mohs hardness is not particularly limited, and is, for example, 1 or more.

A volume-average particle diameter of the boron nitride aggregated particles is not particularly limited, and is preferably 10 µm or more and more preferably 15 µm or more. When the volume-average particle diameter is the lower limit value or more, the number of particles is relatively small in the resin composition and the cured product using the resin composition, so that the heat resistance is reduced by reducing an interface between particles, and the composite resin sheet may have high thermal conductivity.

In addition, the volume-average particle diameter of the boron nitride aggregated particles is preferably 100 µm or less and more preferably 90 µm or less. When the volume-average particle diameter is the upper limit value or less, surface smoothness of the cured product using the resin composition tends to be obtained.

Here, the volume-average particle diameter of the boron nitride aggregated particles means a particle diameter when the cumulative volume becomes 50% when a cumulative curve is drawn with a volume of the powder used for the measurement of 100%. As the measurement method, a wet measurement method for performing measurement with respect to a sample obtained by dispersing the aggregated particles in a pure water medium containing sodium hexametaphosphate as a dispersion stabilizer using a laser diffraction/scattering particle size distribution measurement device or the like, and a dry measurement method for performing measurement using "Morphologi" manufactured by Malvern are exemplary examples. The same also applies to a spherical filler which will be described later.

### [Content of Aggregated Inorganic Filler]

A content of the aggregated inorganic filler in the resin composition of the present invention is preferably 20% by mass or more, more preferably 30% by mass or more, even more preferably 40% by mass or more, and particularly preferably 50% by mass or more with respect to 100% by mass of the resin composition. In addition, the content of the aggregated inorganic filler in the resin composition of the present invention is preferably 99% by mass or less, more preferably 90% by mass or less, and particularly preferably 80% by mass or less with respect to 100% by mass of the resin composition.

Further, a combination of an upper limit value and a lower limit value of the content of the aggregated inorganic filler is not particularly limited, and is preferably 20% by mass or more and 99% by mass or less, more preferably 30% by mass or more and 99% by mass or less, even more preferably 40% by mass or more and 90% by mass or less, and particularly preferably 50% by mass or more and 80% by mass or less.

When the content of the aggregated inorganic filler is the lower limit value or more, the effect of improving the thermal conductivity and the effect of controlling the coefficient of linear expansion by containing the aggregated inorganic filler tend to be sufficiently obtained. In addition, when the content of the aggregated inorganic filler is the upper limit value or less, moldability of the resin cured product and interface adhesiveness in the composite molded product tend to be improved.

When another non-aggregated inorganic filler is used in combination in addition to the aggregated inorganic filler, a content ratio of the aggregated inorganic filler to the other non-aggregated inorganic filler in the resin composition is not particularly limited, and is preferably 90: 10 to 10:90 and more preferably 80:20 to 20:80 in terms of a mass ratio.

### [Breaking Strength of Aggregated Inorganic Filler]

A breaking strength of the aggregated inorganic filler is not particularly limited, and is preferably 300 MPa or less, more preferably 100 MPa or less, even more preferably 50 MPa or less, further preferably 20 MPa or less, particularly preferably 15 MPa or less, and most preferably 10 MPa or less. When the breaking strength is the upper limit value or less, an aggregated structure of the aggregated inorganic filler is deformed during the press process, and the aggregated inorganic fillers are likely to come into surface contact with each other. On the other hand, the lower limit value of the breaking strength is not particularly limited, and the breaking strength is preferably 2.5 MPa or more, more preferably 3 MPa or more, even more preferably 3.5 MPa or more, and particularly preferably 4 MPa or more, from the viewpoint of handleability.

When the breaking strength of the aggregated inorganic filler is within the numerical range described above, the aggregated inorganic fillers are deformed at a portion where the aggregated inorganic fillers are in contact with each other, and the surface contact tends to be easily performed. While maintaining high thermal conductivity inside the aggregated inorganic filler, contact heat resistance at an interface between the aggregated inorganic fillers and an interface between the metal substrate and the heat dissipation sheet, which will be described later, can be reduced, and the overall thermal conductivity can be improved.

### [Elastic Modulus of Aggregated Inorganic Filler]

The elastic modulus of the aggregated inorganic filler is not particularly limited, and is preferably 10 MPa or more, more preferably 20 MPa or more, even more preferably 30 MPa or more, particularly preferably 50 MPa or more, and most preferably 55 MPa or more. When the elastic modulus is the lower limit value or more, the aggregated inorganic filler is plastically deformed in a direction of the press pressure, and collapse of the aggregated structure tends to be suppressed. On the other hand, the upper limit value of the elastic modulus is not particularly limited, and is preferably 5 GPa or less, more preferably 2 GPa or less, even more preferably 1.5 GPa or less, further preferably 1 GPa or less, even further preferably 500 MPa or less, particularly preferably 300 MPa or less, and most preferably 150 MPa or less, from the viewpoint of easily realizing sufficient deformation.

When the elastic modulus of the aggregated inorganic filler is within the numerical range described above, a spherical shape tends to be easily maintained during a press process and the like.

When the aggregated inorganic filler is in the heat dissipation sheet, the breaking strength and elastic modulus of the aggregated inorganic filler can be measured after baking the resin of the heat dissipation sheet and extracting the aggregated inorganic filler so that the aggregated inorganic filler is not changed in quality.

### [Other Non-Aggregated Inorganic Filler]

In addition to the aggregated inorganic filler, other non-aggregated inorganic fillers may be used in combination. For the other non-aggregated inorganic filler, a spherical filler is an exemplary example in addition to those described above. The other non-aggregated filler is not limited to a spherical filler. For example, scaly boron nitride primary particles and the like are exemplary examples, and there is no limitation to the spherical filler.

A thermal conductivity of the spherical filler is preferably 10 W/m · K or more, more preferably 15 W/m · K or more, and even more preferably 20 W/m · K or more. The thermal conductivity of the spherical filler is preferably, for example, 10 to 30 W/m . K. A new Mohs hardness of the spherical filler is preferably 3.1 or more. The new Mohs hardness of the spherical filler is preferably, for example, 5 to 10. By using such a spherical filler in combination with the aggregated inorganic filler described above, it is possible to increase an adhesive force and heat dissipation property of the obtained resin cured product to the metal.

Here, the "spherical shape" may be anything that is generally recognized as a spherical shape, and for example, an average circularity of 0.4 or more may be set as the spherical shape, or 0.6 or more may be set as the spherical shape. Generally, an upper limit of the average circularity is 1. The circularity can be measured by image processing a projected image, and can be measured by, for example, FPIA series of Sysmex Corporation.

The spherical filler is preferably at least one or more kinds selected from the group consisting of alumina, synthetic magnesite, crystalline silica, aluminum nitride, silicon nitride, silicon carbide, zinc oxide, and magnesium oxide. By using these preferable spherical fillers, the heat dissipation property of the obtained resin cured product can be further increased.

An average particle diameter of the spherical filler is preferably 0.5 µm or more and 40 µm or less. When the average particle diameter is 0.5 µm or more, it is considered that the resin and the filler can easily flow during heat molding, and the interface adhesive force in the composite molded product of the present invention can be increased. In addition, when the average particle diameter is 40 µm or less, it is easy to maintain the dielectric breakdown characteristics of the resin cured product.

There is no limitation on the shape of the inorganic filler, and it may be in the form of particles, whiskers, fibers, plates, or an aggregate thereof.

### [Organic Filler]

In addition to the aggregated inorganic filler, an organic filler may be used in combination. In the present invention, the organic filler does not contain an epoxy group, does not correspond to a thermosetting catalyst, and is a component which is composed of an organic component and is solid at room temperature. For the organic filler, a natural product such as wood flour, cellulose and starch which may be modified, various organic pigments, thermoplastic resins, thermosetting resins, and the like are exemplary examples. Specific examples thereof include acrylic resin particles, nylon resin particles, polyester resin particles, polystyrene resin particles, silicone resin particles, and the like. These may be used alone or in combination of two or more.

When the organic filler is contained, it may be possible to impart appropriate extensibility to the resin composition, alleviate stress to be generated, and suppress the occurrence of cracks in a temperature cycle test.

An upper limit of an average particle diameter of the organic filler is preferably 100 µm or less, more preferably 50 µm or less, even more preferably 30 µm or less. When the average particle diameter of the organic filler is the upper limit value or less, it is possible to reduce risks of a decrease in thermal conductivity when producing heat-dissipating insulating sheets having various thicknesses. The particle diameter of the organic filler is also an average particle diameter obtained from a particle size distribution measurement result of a volume average measured by the laser diffraction type particle size distribution measurement device.

### (Thermosetting Resin)

The thermosetting resin contained in the resin composition of the present invention is not particularly limited, as long as it can be cured in the presence of a curing agent and a curing catalyst to obtain a cured product.

Specifically, for the thermosetting resin, an epoxy resin, a phenol resin, a polycarbonate resin, an unsaturated polyester resin, a urethane resin, a melamine resin, and a urea resin, and the like are exemplary examples. Among these, the epoxy resin is preferable from the viewpoints of viscosity, heat resistance, hygroscopicity, and handleability. For the epoxy resin, an epoxy group-containing silicon compound, an aliphatic epoxy resin, a bisphenol A type epoxy resin, a bisphenol F type epoxy resin, a novolak type epoxy resin, an alicyclic epoxy resin, a glycidyl ester type epoxy resin, a polyfunctional epoxy resin, a polymer type epoxy resin, and the like are exemplary examples.

### [Epoxy Resin]

The epoxy resin is a general term for compounds having one or more oxylan rings (epoxy groups) in a molecule. In addition, the oxylan ring (epoxy group) contained in the epoxy resin may be either an alicyclic epoxy group or a glycidyl group, but the glycidyl group is more preferable from the viewpoints of the reaction rate and the heat resistance.

The epoxy resin used in the present invention may be an aromatic oxylan ring (epoxy group)-containing compound. As specific examples, a bisphenol type epoxy resin obtained by glycidylating bisphenols such as bisphenol A, bisphenol F, bisphenol AD, bisphenol S, tetramethyl bisphenol A, tetramethyl bisphenol F, tetramethyl bisphenol AD, tetramethyl bisphenol S, and tetrafluoro bisphenol A; an epoxy resin obtained by glycidylating divalent phenols such as a biphenyl-based epoxy resin, dihydroxynaphthalene, and 9,9-bis (4-hydroxyphenyl) fluorene; an epoxy resin obtained by glycidylating trisphenols such as 1,1,1-tris (4-hydroxyphenyl)methane; an epoxy resin obtained by glycidylating tetrakisphenols such as 1, 1,2,2-tetrakis (4-hydroxyphenyl) ethane; a novolak type epoxy resin obtained by glycidylating novolaks such as phenol novolak, cresol novolak, bisphenol A novolak, and brominated bisphenol A novolak; and the like are exemplary examples.

The epoxy resin contained in the resin composition of the present invention is not particularly limited, and for example, at least one or more kinds selected from the group consisting of various bisphenol type epoxy resins obtained by glycidylating bisphenols such as bisphenol A type epoxy resin and bisphenol F type epoxy resin; various biphenyl type epoxy resins obtained by glycidylating biphenyls, an epoxy resin obtained by glycidylating compounds having aromatic property containing two hydroxyl groups such as dihydroxynaphthalene and 9,9-bis (4-hydroxyphenyl) fluorene; an epoxy resin obtained by glycidylating trisphenols such as 1,1,1-tris (4-hydroxyphenyl)methane, an epoxy resin obtained by glycidylating tetrakisphenols such as 1,1,2,2-tetrakis (4-hydroxyphenyl) ethane; a novolak type epoxy resin obtained by glycidylating novolaks such as phenol novolak, cresol novolak, bisphenol A novolak, and brominated bisphenol A novolak; and a silicone-containing epoxy resin are preferable.

It is more preferable that the epoxy resin used in the present invention contain a polyfunctional epoxy resin. The polyfunctional epoxy resin is an epoxy resin having three or more oxylan rings (epoxy groups) per molecule.

From the viewpoint of increasing a storage elastic modulus of the resin cured product of the present invention, particularly increasing the storage elastic modulus at high temperature, an epoxy resin having two or more oxylan rings (epoxy groups) in a molecule is preferable, an epoxy resin having three or more oxylan rings (epoxy groups) in a molecule is more preferable, and an epoxy resin having four or more glycidyl groups in a molecule is even more preferable. The storage elastic modulus of the resin cured product at high temperature is important when a heat generation amount of the power semiconductor or the like is large.

By including a plurality of oxylan rings (epoxy groups), particularly glycidyl groups in the molecule, a crosslink density of the cured product is improved, and the obtained resin cured product has higher strength. Therefore, when an internal stress is generated in the resin cured product in a hygroscopicity reflow test, the resin cured product does not deform or break and maintains its morphology, so that generation of cavities such as voids or the like in the resin cured product can be suppressed.

In addition, from the viewpoint of increasing the storage elastic modulus of the resin cured product, a molecular weight of the polyfunctional epoxy resin is preferably 1,000 or less and preferably 800 or less. In addition, a lower limit value of the molecular weight of the polyfunctional epoxy resin is not particularly limited, and is, for example, 100 or more.

By adding the polyfunctional epoxy resin, it is possible to introduce an oxylan ring (epoxy group) having high polarity at a high density. Accordingly, an effect of physical interaction such as van der Waals force and hydrogen bonding is increased, and the adhesion between the metal and the resin cured product in the composite molded product can be improved.

In addition, by adding a polyfunctional epoxy resin, it is possible to increase the storage elastic modulus of the resin cured product after thermosetting. Therefore, after the cured product of the resin composition has covered uneven surface of the metal, a strong anchoring effect can be exhibited and the adhesion between the metal and the resin cured product can be improved.

Meanwhile, with the introduction of a polyfunctional epoxy resin, hygroscopicity of the resin composition tends to increase, but by improving reactivity of the oxylan ring (epoxy group), the amount of hydroxyl group during the reaction can be reduced and an increase in hygroscopicity can be suppressed. Further, by producing the resin composition by combining the epoxy resin described above and the polyfunctional epoxy resin, it is possible to achieve both high elasticity and low hygroscopicity of the resin cured product.

As the polyfunctional epoxy resin, specifically, an epoxy resin having three or more epoxy groups is preferable, and for example, EX321L, DLC301, DLC402 manufactured by Nagase ChemteX, BATG, PETG manufactured by Showa Denko, and the like can be used.

These polyfunctional epoxy resins may be used alone, or may be used in combination of two or more kinds thereof.

### [Content of Thermosetting Resin]

When the resin composition further contains the solvent optionally, a content of the thermosetting resin in the resin composition of the present invention is preferably 5 to 90% by mass and more preferably 10 to 60% by mass with respect to 100% by mass of the resin composition excluding the inorganic filler and the solvent. When the content of the thermosetting resin is the lower limit value or more, the moldability is favorable. When the content of the thermosetting resin is the upper limit value or less, the content of other components can be secured and the thermal conductivity can be increased.

In addition, when the solvent, the inorganic filler, and the thermosetting catalyst are removed from the resin composition of the present invention, the main component thereof is preferably the epoxy resin. Here, the main component refers to the most abundant component.

A proportion of the epoxy resin in the resin composition excluding the inorganic filler and the thermosetting catalyst is not particularly limited, and is preferably 20% by mass or more and preferably 45% by mass or more.

In addition, the upper limit value of the proportion of the epoxy resin is 100% by mass, and all of them may be epoxy resin. When the proportion of the epoxy resin is within the range described above, low hygroscopicity, high elastic modulus, high toughness, and reaction control are easily achieved, and the effects of high reflow resistance, high reliability in a cycle test, and high thermal conductivity tend to be exhibited.

The resin composition of the present invention preferably contains 5% by mass or more of the polyfunctional epoxy resin, which is the suitable epoxy resin described above, and more preferably contains 10% by mass or more of the polyfunctional epoxy resin in the entire epoxy resin. In addition, the resin composition of the present invention preferably contains 50% by mass or less of the polyfunctional epoxy resin and more preferably 40% by mass or less of the polyfunctional epoxy resin in the entire epoxy resin. When the content of the polyfunctional epoxy resin is the lower limit value or more, the effect described above obtained by containing the polyfunctional epoxy resin can be effectively obtained. On the other hand, when the content of the polyfunctional epoxy resin is the upper limit value or less, the hygroscopicity of the cured product is suppressed and the strength performance of the cured product is excellent, and both of these can be achieved.

From the viewpoints of film-forming property, low hygroscopicity, and flexibility, it is more preferable that the epoxy resin used in the present invention contain an epoxy resin having a high molecular weight. Specifically, the epoxy resin having a high molecular weight is preferably an epoxy resin having a mass-average molecular weight of 10,000 or more, more preferably an epoxy resin having a mass-average molecular weight of 20,000 or more, and the mass-average molecular weight thereof is particularly preferably 30,000 or more. In addition, the epoxy resin having a high molecular weight is preferably an epoxy resin having a mass-average molecular weight of 100,000 or less and more preferably an epoxy resin having a mass-average molecular weight of 80,000 or less.

The epoxy resin having a high molecular weight is preferably more hydrophobic. Specifically, 5,000 g/equivalent or more is preferable, and 7,000 g/equivalent or more is more preferable. In addition, it is preferably 20,000 g/equivalent or less.

Here, the mass-average molecular weight of the epoxy resin is a polystyrene-equivalent value measured by gel permeation chromatography. In addition, the epoxy equivalent is defined as a "mass of the epoxy resin containing 1 equivalent of the epoxy group" and can be measured according to JIS K7236.

The epoxy resin having a high molecular weight may be used alone, or may be used in combination of two or more kinds thereof. Epoxy resins other than high-molecular-weight epoxy resins may be further used in combination.

### (Thermosetting Catalyst)

In the resin composition of the present invention, the thermosetting catalyst contains two or more thermosetting catalysts having a melting point of 100°C or higher. By using these thermosetting catalysts, the reaction rate of the thermosetting resin during the storage can be reduced. In addition, when performing the curing in the molding pressurization step or the like, the curing reaction can sufficiently proceed.

When the resin composition contains only one, that is, one kind of thermosetting catalyst, it is difficult to obtain the effect of the present invention. For example, when the number of single thermosetting catalysts is excessively increased in order to increase the reaction rate, the storage stability of the resin composition may be deteriorated. As the reaction rate increases, the deformation and contact of the inorganic filler during the pressurization are hindered. Accordingly, the resin cured product tends not to have high thermal conductivity. On the other hand, when the number of single thermosetting catalysts is excessively reduced, the curing rate decreases. As a result, the resin composition is poorly cured, resulting in a resin cured product having a low elastic modulus and high hygroscopicity. Therefore, in the hygroscopicity reflow test, the interface between the metal and the resin cured product tends to be peeled off, or the voids in the resin cured product tend to expand, thereby decreasing insulating property. Therefore, it is important to use two or more thermosetting catalysts having a melting point of 100°C or higher in combination, while controlling the curing rate at the time of pressurization so that the final cured product is not poorly cured.

The thermosetting catalyst is not particularly limited as long as two or more thermosetting catalysts having a melting point of 100°C or higher are used. In addition, the melting point of at least one or more kinds is preferably 200°C or higher, and the melting point of two or more kinds is more preferably 200°C or higher. When the melting point of one or more kinds is 200°C or higher, the reaction rate of the thermosetting resin during the storage can be further reduced, which is more preferable from the viewpoint of storage stability.

A difference (absolute value) in the melting points of the two or more kinds of thermosetting catalysts is not particularly limited, and is preferably 100°C or lower and more preferably 80°C or lower. In addition, it is preferably 5°C or higher. Within these ranges, the reaction rate of the thermosetting resin during the storage can be reduced, and when the curing is performed in the molding pressurization step or the like, the curing reaction tends to sufficiently proceed.

For the thermosetting catalyst having a melting point of 100°C or higher, an imidazole compound; chain or cyclic tertiary amine; an organic phosphorus compound; quaternary phosphonium salts, diazabicycloalkenes such as organic acid salts, and the like are exemplary examples. In addition, organometallic compounds, quaternary ammonium salts, metal halides, and the like can also be used. For the organometallic compounds, zinc octylate, tin octylate, and an aluminum acetylacetone complex are exemplary examples.

From the viewpoint of increasing the effect of improving the adhesion between the resin cured product of the present invention and the metal, two or more kinds of the thermosetting catalysts have a structure derived from imidazole.

In addition, in order to improve the adhesion and suppress the peeling after reflow, it is preferable that the thermosetting catalyst further have a structure derived from triazine. In particular, it is preferable that at least one kind of thermosetting catalyst having a structure derived from imidazole further have a structure derived from triazine in one molecule, from the viewpoint of adhesion. Two or more kinds of thermosetting catalysts may have a structure derived from imidazole and a structure derived from triazine in one molecule. With these structures, the structure derived from triazine acts with the metal by hydrogen bonding or the like to improve the adhesion, and at the same time, polarization of the epoxy starts from the structure derived from imidazole in the same molecule, so that the adhesion between the resin cured product and the metal tends to be further improved.

For the preferable imidazole-based compound and triazine-based compound having a melting point of 100°C or higher, 2,4-diamino-6-[2'-ethyl-4'-methylimidazolyl-(17')]-ethyl-s-triazine, 2-phenyl-4,5-dihydroxymethylimidazole, 2-methylimidazole, 2-phenylimidazole, 2-phenyl-4-methylimidazole, 1-cyanoethyl-2-phenylimidazole, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, and the like are exemplary examples.

Among these, the structure derived from imidazole and the structure derived from triazine are particularly preferable, the structure derived from triazine is particularly preferable, and as triazine, a structure derived from 1,3,5-triazine is particularly preferable. In addition, the structure may have a plurality of these exemplified structural parts. Since these structures have high compatibility with the thermosetting resin and have a high reaction activation temperature, the curing rate and the physical properties after the curing can be easily adjusted. Therefore, there is a tendency that the storage stability of the resin composition can be improved and the adhesive strength after heat molding can be further improved.

### [Content of Thermosetting Catalyst]

A content of the thermosetting catalyst is preferably 0.1 to 10% by mass, more preferably 0.1 to 5% by mass, and even more preferably 0.5 to 4% by mass with respect to 100% by mass of the resin composition of the present invention excluding the solvent and the inorganic filler. When the content of the curing catalyst is the lower limit value or more, the progress of the curing reaction is sufficiently promoted and the curing can be performed favorably. When the content of the curing catalyst is the upper limit value or less, the curing rate will not be too fast. Therefore, when the content of the thermosetting catalyst is within the numerical range described above, the storage stability of the resin composition of the present invention is favorable, the thermal conductivity of the cured product is improved, and the voids in the cured product are removed efficiently, thereby improving the insulating property.

Here, the solvent is not an essential component in the resin composition of the present invention. That is, the resin composition of the present invention may or may not contain a solvent.

When the resin composition of the present invention contains a solvent, the content of the thermosetting catalyst is expressed as a ratio (% by mass) to a total amount of the resin composition excluding the amounts of the solvent and the inorganic filler.

When the resin composition of the present invention does not contain a solvent, the content of the thermosetting catalyst is expressed as a ratio (% by mass) to a total amount of the resin composition excluding the amount of the inorganic filler.

In addition, a content of the thermosetting catalyst having the structure derived from triazine in one molecule is preferably 0.01 to 5% by mass, more preferably 0.15 to 5% by mass, and even more preferably 0.2 to 4% by mass with respect to 100% by mass of the resin composition excluding the inorganic filler and the solvent. When the content is in these ranges, the adhesion to a copper plate or the like tends to be improved.

In addition, a content of the thermosetting catalyst having both of the structure derived from imidazole and the structure derived from triazine in one molecule is preferably 0.1 to 5% by mass, more preferably 0.5 to 4% by mass, and even more preferably 0.7 to 3% by mass with respect to 100% by mass of the resin composition excluding the inorganic filler and the solvent. When the content is the lower limit value or more, the progress of the curing reaction is sufficiently promoted and the curing can be performed favorably. When the content of the thermosetting catalyst having both of the structure derived from imidazole and the structure derived from triazine in one molecule is the upper limit value or less, the curing rate is not too fast. Accordingly, the storage stability of the resin composition of the present invention is favorable, the thermal conductivity of the cured product is improved, and the voids in the cured product are removed efficiently, thereby improving insulating property.

The average particle diameter of the thermosetting catalyst is not particularly limited, and an average particle diameter of at least one or more kinds of thermosetting catalysts is preferably 15 µm or less and more preferably 10 µm or less. In addition, the average particle diameter of at least one or more kinds of thermosetting catalyst is preferably 50 nm or more, more preferably 100 nm or more, even more preferably 500 nm or more, and still more preferably 1000 nm or more. When the average particle diameter is the upper limit value or less, the solubility of the thermosetting catalyst in the resin component tends to be improved and the reaction rate tends to be improved. In addition, the elastic modulus of the resin cured product can be increased and a glass transition temperature tends to be increased. Further, the dispersibility of the thermosetting catalyst tends to be improved and the storage stability tends to be improved.

On the other hand, when the average particle diameter is the lower limit value or more, secondary aggregation of the thermosetting catalyst itself is suppressed, the dispersibility of the thermosetting catalyst is improved, and the storage stability of the resin composition tends to be improved. In addition, the handleability of the resin composition during production tends to be favorable.

The average particle diameter of the plurality of thermosetting catalysts is not particularly limited, and the average particle diameter of the plurality of thermosetting catalysts may be in the range described above.

Regarding at least one kind of the thermosetting catalyst of the present invention, a solubility in N,N-dimethylformamide (DMF) at 25°C is preferably 10% by mass or less and more preferably 8% by mass or less. The lower limit value of the solubility in DMF is not particularly limited, and may be, for example, 0.01% by mass or less. In addition, the solubility of two or more kinds of thermosetting catalysts in DMF is particularly preferably 10% by mass or less. Since the DMF is a highly polar solvent, the thermosetting catalyst is insoluble in DMF. Accordingly, the reaction of the thermosetting catalyst is suppressed and the storage stability of the resin composition tends to be improved.

### (Curing Agent)

The resin composition of the present invention may further contain a curing agent. The curing agent is not particularly limited, and for example, a phenol resin, an acid anhydride having an aromatic skeleton or an alicyclic skeleton, a compound produced by hydrogenation of the acid anhydride, and a modified product of the acid anhydride are preferable. By using these preferable curing agents, it tends to be possible to obtain a resin cured product having an excellent balance between heat resistance, moisture resistance, and electrical characteristics. The curing agent may be used alone or may be used in combination of two or more kinds thereof.

A phenol resin used as the curing agent is not particularly limited. For the phenol resin, phenol novolak, o-cresol novolak, p-cresol novolak, t-butylphenol novolak, dicyclopentadiencresol, polyparavinylphenol, bisphenol A type novolak, xylylene-modified novolak, decalin-modified novolak, poly(di-o-hydroxyphenyl) methane, poly(di-m-hydroxyphenyl) methane, poly(di-p-hydroxyphenyl) methane, and the like are specific exemplary examples. In particular, in order to further improve flexibility and flame retardancy of the resin composition and to improve mechanical properties and heat resistance of the resin cured product, a novolak type phenol resin having a rigid main chain skeleton; and a phenol resin having a triazine skeleton are preferable. In addition, in order to improve the flexibility of the resin composition and toughness of the resin cured product, a phenol resin having an allyl group is preferable.

For commercially available products of the phenol resin, MEH-8005, MEH-8000H, and NEH-8015 manufactured by Meiwa Kasei Co., Ltd.; YLH903 manufactured by Mitsubishi Chemical Corporation; LA-7052, LA-7054, LA-7751, LA-1356, and LA-3018-50P manufactured by Dainippon Ink Co., Ltd.; PSM6200, PS6313, and PS6492 manufactured by Gun Ei Chemical Industry Co., Ltd. are exemplary examples.

The acid anhydride having an aromatic skeleton, the water additive of the acid anhydride, and the modified product of the acid anhydride used for the curing agent are not particularly limited. For those, SMA resin EF30 and SMA resin EF60 manufactured by Sartmer Japan; ODPA-M and PEPA manufactured by Manac; RIKACID MTA-10, RIKACID TMTA RIKACID TMEG-200, RIKACID TMEG-500, RIKACID TMEG-S, RIKACID TH, RIKACID MH-700, RIKACID MT-500, RIKACID DSDA, and RIKACID TDA-100; manufactured by New Japan Chemical Co., Ltd.; EPICLON B4400 and EPICLON B570 manufactured by Dainippon Ink and Chemicals; and the like are exemplary examples.

The acid anhydride having an alicyclic skeleton, the water additive of the acid anhydride, and the modified product of the acid anhydride are preferably an acid anhydride having a polyalicyclic skeleton, the water additive of the acid anhydride, and the modified product of the acid anhydride, and an acid anhydride having an alicyclic skeleton obtained by an additive reaction between a terpene-based compound and maleic anhydride, the water additive of the acid anhydride, and the modified product of the acid anhydride. For these, RIKACID HNA and RIKACID HNA-100 manufactured by Shin Nihon Rika Co., Ltd.; Epicure YH306 and Epicure YH309 manufactured by Mitsubishi Chemical Corporation; and the like are specific exemplary examples.

The curing agent is preferably contained in an amount of 0 to 70% by mass and particularly preferably 0 to 55% by mass with respect to 100% by mass of the resin composition excluding the inorganic filler and the solvent. When the content of the curing agent is the lower limit value or more, sufficient curing performance can be obtained. When the content of the curing agent is the upper limit value or less, the curing reaction proceeds effectively, the crosslink density is improved, the strength can be increased, and the film-forming property is further improved.

When the thermosetting resin is an epoxy resin, a content of a reactive group of the curing agent is not particularly limited, and may be 0 equivalents and is preferably 0.05 equivalents or more, more preferably 0.1 equivalents or more, even more preferably 0.15 equivalents or more, and particularly preferably 0.2 equivalents or more with respect to the amount of the epoxy group in the thermosetting resin. In addition, the content thereof is preferably 2 equivalents or less, more preferably 0.9 equivalents or less, even more preferably 0.6 equivalents or less, and particularly preferably 0.4 equivalents or less with respect to the amount of epoxy group in the thermosetting resin.

When the content of the reactive group of the curing agent is the lower limit value or more with respect to the amount of the epoxy group in the thermosetting resin, a decrease in the curing rate is suppressed, it is difficult for the epoxy group to remain, and the effect of improving the strength of the resin cured product and suppressing the hygroscopicity tends to be obtained. On the other hand, when the content thereof is the upper limit value or less, the elastic modulus of the resin cured product tends to increase.

### (Other Components)

The resin composition of the present invention may further contain components other than the inorganic filler, the thermosetting resin, the thermosetting catalyst, and the curing agent, as long as the effects of the present invention are not impaired.

As other components, a surface treatment agent such as a silane coupling agent; an insulating carbon component such as a reducing agent; a viscosity modifier; a dispersing agent; a thixotropy-imparting agent; a flame retardant; a colorant; an organic solvent; a thermoplastic resin; and the like that improve adhesive strength of an interface between the inorganic filler and the resin composition used in some cases when producing the resin cured product using the resin composition are exemplary examples.

Among these, when the resin composition further contains a dispersing agent, it may be possible to form a uniform resin cured product and it may be possible to improve the thermal conductivity and dielectric breakdown characteristics of the obtained resin cured product. In addition, when the resin composition further contains the thermoplastic resin, it may be possible to impart appropriate extensibility to the resin composition, alleviate stress to be generated, and suppress the occurrence of cracks in a temperature cycle test.

The dispersing agent preferably has a functional group containing a hydrogen atom having a hydrogen bonding property. When the dispersing agent has a functional group containing hydrogen atoms having hydrogen bonding property, the thermal conductivity and dielectric breakdown characteristics of the resin cured product can be further increased. For the functional group containing a hydrogen atom having a hydrogen bonding property, a carboxyl group (pKa = 4), a phosphate group (pKa = 7), a phenol group (pKa = 10), and the like are exemplary examples.

The pKa of the functional group containing the hydrogen atom having the hydrogen bonding property is preferably 2 to 10 and more preferably 3 to 9. When the pKa is 2 or more, the acidity of the dispersing agent is in an appropriate range, and the reaction of the epoxy resin in the thermosetting resin component may be easily suppressed. Therefore, when an uncured molded body is stored, the storage stability tends to be improved. When the pKa is 10 or less, the function of the dispersing agent is sufficiently exhibited, and the thermal conductivity and dielectric breakdown characteristics of the resin cured product tend to be sufficiently increased.

As the functional group containing the hydrogen atom having the hydrogen bonding property, a carboxyl group and a phosphate group are preferable. In this case, the thermal conductivity and dielectric breakdown characteristics of the resin cured product can be further increased.

For the dispersing agent, polyester-based carboxylic acid, polyether-based carboxylic acid, polyacrylic carboxylic acid, aliphatic carboxylic acid, polysiloxane-based carboxylic acid, polyester-based phosphoric acid, polyether-based phosphoric acid, polyacrylic phosphoric acid, aliphatic phosphoric acid, polysiloxane-based phosphoric acid, polyester-based phenol, polyether-based phenol, polyacrylic-based phenol, polysiloxane-based phenol, and the like are specific exemplary examples. The dispersing agent may be used alone or in combination of two or more.

As the thermoplastic resin, any generally well-known thermoplastic resin can also be used. A vinyl-based polymer such as polyethylene, polypropylene, polystyrene, polyvinyl chloride, a (meth)acrylic resin, an ethylene-vinyl acetate copolymer, an ethylene-vinyl alcohol copolymer; polyester such as a polylactic acid resin, polyethylene terephthalate, and polybutylene terephthalate; polyamide such as nylon and polyamide amine; a polyvinyl acetal resin such as polyvinylacetacetal, polyvinylbenzal, and a polyvinylbutyral resin; an ionomer resin, polyphenylene ether, polyphenylene sulfide, polycarbonate, polyether ether ketone, polyacetal, an ABS resin, a liquid crystal polymer (LCP), fluororesin, a urethane resin, a silicone resin, and various elastomers are specific exemplary examples. The thermoplastic resin may be a modified product or the like of these exemplified resins.

These thermoplastic resins may be those that are uniform in a resin phase of the resin cured product, or those that are phase-separated and whose shape is recognized. When the thermoplastic resin is phase-separated, the shape of the thermoplastic resin in the resin cured product may be particulate or fibrous. In addition, the thermoplastic resin may be contained as the organic filler described above.

When the thermoplastic resin is contained, it may be possible to impart appropriate extensibility to the resin composition, alleviate stress to be generated, and suppress the occurrence of cracks in a temperature cycle test.

When the thermoplastic resin and the organic filler described above are insoluble in the thermosetting resin, an increase in viscosity of the resin composition is prevented, and the smoothness of a sheet surface can be improved, for example, when the resin composition is molded into a sheet shape as will be described later. In this case, by mixing the thermoplastic resin and the organic filler that are insoluble in the thermosetting resin at the same time as a large amount of the inorganic filler, a component phase for improving thermoplasticity and elongation can be efficiently dispersed in the resin cured product and the stress is easily alleviated. Therefore, it is possible to suppress the occurrence of cracks in the resin cured product without reducing the elastic modulus of the resin cured product. For these reasons, as the thermoplastic resin, a polyamide resin such as nylon, a cellulose resin, and the like are preferable, and a polyamide resin such as nylon or the like is particularly preferable.

The resin composition of the present invention may optionally further contain an organic solvent, for example, in order to improve the coating property when molding a sheet-shaped resin cured product through a coating step.

For the organic solvent that can be contained in the resin composition of the present invention, methyl ethyl ketone, cyclohexanone, propylene glycol monomethyl ether acetate, butyl acetate, isobutyl acetate, propylene glycol monomethyl ether, and the like are exemplary examples. The organic solvent may be used alone or in combination of two or more.

When the resin composition of the present invention optionally further contains the organic solvent, a content of the organic solvent is appropriately determined according to the handleability of the resin composition at the time of producing the resin cured product, the shape before the curing, the drying conditions, and the like. When the resin composition of the present invention is in the form of slurry to be used in the coating step which will be described later, the organic solvent is preferably used so that a concentration of a solid (all components other than the solvent) in the resin composition of the present invention or the resin composition of the present invention after adding the inorganic filler which will be described later is 10 to 90% by mass and particularly 40 to 80% by mass.

When the resin composition of the present invention is in the form of a sheet that has undergone steps such as coating and drying, the organic solvent is preferably used so that the concentration of the solid (all components other than the solvent) in the resin composition of the present invention or the resin composition of the present invention after adding the inorganic filler which will be described later is 95% by mass or more and more preferably 98% by mass or more.

### [Producing of Resin Composition and Resin Cured Product]

The method for producing the resin composition of the present invention and the resin cured product of the present invention will be described below by exemplifying a method for producing a sheet-shaped resin cured product formed of the resin cured product of the present invention.

The sheet-shaped resin cured product can be produced by a normally used method. For example, it can be obtained by preparing the resin composition of the present invention, molding the resin composition into a sheet, and curing it.

The resin composition can be obtained by uniformly mixing the inorganic filler, the thermosetting resin, the thermosetting catalyst, and other components added as necessary, by stirring and kneading.

For the mixing, for example, a general kneading device such as a mixer, a kneader, a single-screw kneader, or a twin-screw kneader can be used, and during the mixing, heating may be performed, if necessary.

The mixing order of each blending component is also optional, as long as there are no particular problems such as reaction and generation of precipitates. For example, a method for preparing a resin solution by mixing and dissolving a thermosetting resin component in an organic solvent (for example, methyl ethyl ketone), adding a material obtained by sufficiently mixing an inorganic filler and other components to the obtained resin solution and mixing, then, adding and mixing an organic solvent thereto for adjustment of viscosity, and adding and mixing additives such as a curing agent, a curing accelerator, or a dispersing agent is used.

As a method for molding and curing the prepared resin composition into a sheet shape, a generally used method can be used.

As the method for molding the slurry-like resin composition into a sheet shape, it can also be obtained by molding the resin composition into a sheet shape by a method such as a doctor blade method, a solvent casting method, or an extrusion film-forming method.

The solvent in the resin composition can be removed by a well-known heating method such as a hot plate, a hot air furnace, an IR heating furnace, a vacuum dryer, and a high-frequency heater.

Hereinafter, an example of a method for producing a resin cured product using a slurry-like resin composition will be described.

### [Coating Step]

First, a slurry-like resin composition is applied to a surface of a base material to form a coating film (sheet-shaped resin composition). Specifically, the slurry-like resin composition is used to form a coating film on the base material by a dip method, a spin coating method, a spray coating method, a blade method, or any other methods. A coating device such as a spin coater, a slit coater, a die coater, or a blade coater can be used for coating the slurry-shaped resin composition. By using the coating device, it is possible to uniformly form the coating film having any film thickness on the base material.

As the base material, a copper foil and a PET film which will be described later are generally used, but are not particularly limited.

### [Drying Step]

The coating film formed by applying the slurry-like resin composition is usually dried at 10°C to 150°C, preferably 25°C to 120°C, and more preferably 30°C to 110°C, in order to remove the solvent and a low-molecular-weight component. When the drying temperature is the upper limit value or lower, the curing of the thermosetting resin in the slurry-like resin composition is suppressed, the resin in the sheet-shaped resin composition flows in the subsequent pressurization step, and the voids tend to be easily removed. In addition, when the drying temperature is the lower limit value or more, the solvent can be effectively removed and productivity tends to be improved.

The drying time is not particularly limited, and can be appropriately adjusted depending on a state of the slurry-like resin composition, the drying environment, and the like. The drying time is preferably 1 minute or longer, more preferably 2 minutes or longer, even more preferably 5 minutes or longer, still more preferably 10 minutes or longer, particularly preferably 20 minutes or longer, and most preferably 30 minutes or longer. On the other hand, the drying time is preferably 4 hours or shorter and more preferably 2 hours or shorter.

When the drying time is the lower limit value or longer, the solvent can be sufficiently removed, and a residual solvent tends to be suppressed from becoming voids in the resin cured product. When the drying time is the upper limit value or shorter, the productivity tends to be improved and the production cost tends to be suppressed.

### [Pressurization Step]

After the drying step, it is desirable to perform the pressurization step with respect to the obtained sheet-shaped resin composition, in order to join the inorganic fillers to each other to form a heat path, to eliminate voids and cavities in the sheet, and improve adhesion to the base material.

In the pressurization step, a heating temperature of the sheet-shaped resin composition on the substrate is not particularly limited. The heating temperature is preferably 10°C or higher, more preferably 20°C or higher, and even more preferably 30°C or higher. The heating temperature is preferably 300°C or lower and more preferably 250°C or lower. When this heating temperature is within the numerical range described above, a melt viscosity of the resin in the coating film can be lowered, and voids and cavities in the resin cured product can be eliminated. In addition, when the resin composition is heated at a temperature of the upper limit value or lower, there is a tendency that decomposition of organic components in the sheet-shaped resin composition and the resin cured product and voids generated by the residual solvent can be suppressed.

The time of the pressurization step is not particularly limited. The time of the pressurization step is preferably 30 seconds or longer, more preferably 1 minute or longer, even more preferably 3 minutes or longer, and particularly preferably 5 minutes or longer. In addition, the time of the pressurization step is preferably 1 hour or shorter, more preferably 30 minutes or shorter, even more preferably 20 minutes or shorter.

When the pressurization time is the upper limit value or shorter, the production time of the resin cured product can be suppressed and the production cost tends to be reduced. On the other hand, when the pressurization time is the lower limit value or longer, the cavities and voids in the resin cured product can be sufficiently removed, and heat transfer performance and voltage resistance tend to be improved.

### [Curing Step]

The curing step of completely performing the curing reaction of the resin composition of the present invention may be performed under pressure or without pressure. In addition, the pressurization step and the curing step may be performed at the same time.

A load when the pressurization step and the curing step are performed at the same time is not particularly limited. The load applied to the sheet-shaped resin composition on the base material is preferably 2 MPa or more, more preferably 5 MPa or more, and even more preferably 9 MPa or more. In addition, the load is preferably 2000 MPa or less and more preferably 1500 MPa or less. When the load is the upper limit value or less, it is possible to obtain a sheet having high thermal conductivity without cavities or the like in the sheet-shaped resin cured product without breaking the secondary particles of the inorganic filler. In addition, when the load is the lower limit value described above, a contact between the inorganic fillers is favorable and the heat conduction path is easily formed. Accordingly, it is possible to obtain a resin cured product having high thermal conductivity.

When the pressurization step and the curing step are performed at the same time, a pressurization time is not particularly limited. The pressurization time in this case is preferably 30 seconds or longer, more preferably 1 minute or longer, even more preferably 3 minutes or longer, and particularly preferably 5 minutes or longer. In addition, the pressurization time in this case is preferably 4 hours or shorter and more preferably 3 hours or shorter. When the pressurization time is the upper limit value or shorter, the production time of the sheet-shaped resin cured product can be suppressed and the production cost tends to be reduced. On the other hand, when the pressurization time is the lower limit value or longer, the cavities and voids in the sheet-shaped resin cured product can be sufficiently removed, and heat transfer performance and voltage resistance tend to be improved.

A heating temperature of the sheet-shaped resin composition on the substrate when the pressurization step and the curing step are performed at the same time is not particularly limited. The heating temperature is preferably 10°C or higher, more preferably 20°C or higher, and even more preferably 30°C or higher. In addition, the heating temperature is preferably 300°C or lower and more preferably 250°C or lower. When this heating temperature is within the numerical range described above, a melt viscosity of the resin in the coating film can be lowered, and voids and cavities in the resin cured product can be eliminated. In addition, when the heating temperature is the upper limit value or lower, there is a tendency that decomposition of organic components in the sheet-shaped resin composition and the sheet-shaped resin cured product and voids generated by the residual solvent can be suppressed.

A heating temperature of the sheet-shaped resin composition on the substrate when only the curing step is performed is not particularly limited. The heating temperature in this case is preferably 10°C or higher, more preferably 50°C or higher, and even more preferably 100°C or higher. The heating temperature in this case is preferably 500°C or lower, more preferably 300°C or lower, and even more preferably 200°C or lower. When the heating temperature is within the numerical range described above, the curing reaction of the resin is effectively promoted. In addition, when the heating temperature is within the numerical range described above, thermal deterioration of the resin can be prevented. Further, when the heating temperature is the lower limit value or higher, the curing reaction of the resin proceeds more effectively.

A thickness of the resin cured product is not particularly limited, and is preferably 50 µm or more, more preferably 80 µm or more, and even more preferably 100 µm or more. In addition, the thickness of the resin cured product is preferably 400 µm or less and more preferably 300 µm or less. When the thickness of the resin cured product is the lower limit value or more, voltage resistance is obtained and the dielectric breakdown voltage tends to be improved. In addition, when the thickness of the resin cured product is the upper limit value or less, the device can be made smaller and thinner, and the heat resistance of the obtained resin cured product(heat dissipation sheet) tends to be suppressed.

### <Composite Molded Product>

The composite molded product of the present invention has the resin cured product of the present invention and a metal. For example, a cured product portion formed of the cured resin cured product of the present invention and a metal portion formed of metal are laminated. The metal portion may be provided on only one surface of the cured product portion formed of the resin cured product of the present invention, or may be provided on two or more surfaces. For example, the resin cured product may have the metal portion on only one surface, or may have the metal portion on both sides. In addition, the metal portion may be patterned.

Such a composite molded product of the present invention can be produced by using the metal portion as the base material and forming the resin cured product of the present invention on the base material according to the method described above. In addition, it can also be produced by peeling the sheet-shaped resin composition or a resin cured product formed on the base material different from the metal portion, from the base material and then heat-pressing it onto a metal member to be the metal portion.

In this case, the sheet-shaped resin composition or resin cured product of the present invention is formed in the same manner as described above except that it is applied onto the base material such as PET which may be treated with a release agent, and then peeled off from the base material, the sheet-shaped resin composition or resin cured product is placed on another metal plate or interposed between two metal plates, and pressurized to be integrated.

In this case, as the metal plate, a metal plate having a thickness of approximately 10 µm to 10 cm formed of copper, aluminum, nickel-plated metal, or the like can be used. In addition, a surface of the metal plate may be physically roughened or chemically treated with a surface treatment agent or the like, and it is more preferable that these treatments be performed from the viewpoint of adhesion between the resin composition and the metal plate.

### <Semiconductor Device>

The semiconductor device of the present invention includes the composite molded product of the present invention. The composite molded product of the present invention can be used as a semiconductor device. Particularly, it can be usefully used in a power semiconductor device capable of increasing output and increasing density by operating at a high temperature.

### [Examples]

Hereinafter, the present invention will be described in more detail with reference to examples, but the present invention is not limited to the following examples. The various conditions and the values of the evaluation results in the following examples indicate preferable ranges of the present invention as in the preferable range in the embodiment of the present invention, and the preferable range of the present invention can be determined in consideration of the preferable ranges in the embodiment described above and the range indicated by the values of the following examples or a combination of values of the examples.

### <Raw Material>

The raw materials used in the examples and comparative examples are as follows.

### (Thermosetting Resin)

· Resin component 1: Bifunctional epoxy resin disclosed in Example 1 of Japanese Unexamined Patent Application First Publication No. 2006-176658
· Resin component 2: Bisphenol F type solid epoxy resin manufactured by Mitsubishi Chemical Corporation

Polystyrene-equivalent mass-average molecular weight: 60,000
· Resin component 3: Bisphenol A type liquid epoxy resin manufactured by Mitsubishi Chemical Corporation
· Resin component 4: Polyfunctional epoxy resin having a structure having four or more glycidyl groups per molecule manufactured by Nagase ChemteX
· Resin component 5: Hydrogenated bisphenol A type liquid epoxy resin manufactured by Mitsubishi Chemical Corporation
· Resin component 6: p-aminophenol type liquid epoxy resin manufactured by Mitsubishi Chemical Corporation
· Resin component 7: Biphenyl type solid epoxy resin manufactured by Mitsubishi Chemical Corporation
· Resin component 8: Polyfunctional epoxy resin having a structure having three or more glycidyl groups per molecule manufactured by Nagase ChemteX

### (Aggregated Inorganic Filler)

· Inorganic filler 1: Boron nitride aggregated particles having a card-house structure manufactured in accordance with the method for producing boron nitride aggregated particles disclosed in examples of PCT International Publication No. WO2015/119198

### (Other Fillers)

· Inorganic filler 2: Spherical alumina particles manufactured by Admatex

New Mohs hardness: 9
Volume-average particle diameter: 6.5 µm
Thermal conductivity: 20 to 30W/m · K

### (Curing Agent)

- Curing agent 1: MEH-8000H manufactured by Meiwa Kasei Co., Ltd. MEH-8000H corresponds to a phenol resin-based curing agent.

### (Thermosetting Catalyst)

· Thermosetting catalyst 1: 2E4MZ-A manufactured by Shikoku Chemicals Corporation.

2E4MZ-A corresponds to 2,4-diamino-6-[2'-ethyl-4'-methylimidazolyl-(17')]-ethyl-s-triazine, and has both of the structure derived from imidazole and the structure derived from triazine in one molecule.
Molecular weight of 2E4MZ-A: 247
Properties of 2E4MZ-A: Solid
Melting point of 2E4MZ-A: 215°C to 225°C
Solubility of 2E4MZ-A in DMF: 10% by mass or less

· Thermosetting catalyst 2: 2PHZ-PW manufactured by Shikoku Chemicals Corporation
   2PHZ-PW is 2-phenyl-4,5-dihydroxymethylimidazole.
   Molecular weight of 2PHZ-PW: 204
   Properties of 2PHZ-PW: Solid
   Melting point of 2PHZ-PW: 230°C or higher (decomposition at 230°C)
   Average particle diameter of 2PHZ-PW: Approximately 3 µm
   Solubility of 2PHZ-PW in DMF: 10% by mass or less
· Thermosetting catalyst 3: C11Z-CN manufactured by Shikoku Chemicals Corporation.
   C11Z-CN is 1-cyanoethyl-2-undecylimidazole.
   Molecular weight of C11Z-CN: 275
   Properties of C11Z-CN: Solid
   Melting point of C11Z-CN: 47°C to 52°C
   Solubility of C11Z-CN in DMF: more than 10% by mass
· Thermosetting catalyst 4: 2MAOK-PW manufactured by Shikoku Chemicals Corporation
   2MAOK-PW is an adduct of 2,4 diamino-6-[2'-methylimidazolyl-(1')]-ethyl-s-triazine isocyanuric acid.
   Molecular weight of 2MAOK-PW: 384
   Properties of 2MAOK-PW: Solid
   Melting point of 2MAOK-PW: 260°C or higher (decomposition at 260°C)
   Average particle diameter of 2MAOK-PW: Approximately 2 µm
   Solubility of 2MAOK-PW in DMF: 10% by mass or less

### <Example 1>

Using a rotating and revolving stirrer, a mixture was prepared so that a resin component 1, a resin component 4, a resin component 7, a curing agent 1, a curing catalyst 1, a curing catalyst 2, an inorganic filler 1, and an inorganic filler 2 formed a composition as disclosed in Table 1 below. In addition, when preparing the mixture, methyl ethyl ketone and cyclohexanone were used as solvents by 18.6% by mass each so that the mixture was 62.8% by mass (solid content concentration) of the coated slurry.

The obtained slurry-like resin composition was applied to a PET base material by the doctor blade method, dried by heating at 60°C for 120 minutes, and then pressurized to obtain a sheet-shaped resin composition having a thickness of 150 µm. The total content of methyl ethyl ketone and cyclohexanone in the sheet-shaped resin composition was 1% by mass or less.

### (Preparation of Resin Cured Product for Measurement of Thermal Conductivity)

A sheet-shaped resin composition was sandwiched between PET and pressurized at 120°C under 9 MPa for 20 minutes to obtain a resin cured product for measuring thermal conductivity. In addition, by pressurizing the sheet-shaped resin composition in a state where two, three, and four sheets thereof were stacked in the same manner, four types of resin cured products having different thicknesses were obtained. These four types of resin cured products having different thicknesses were used as resin cured products for measuring thermal conductivity.

### (Producing of Composite Molded Product for Measuring Peel Strength Ratio)

A sheet-shaped resin composition was sandwiched between two copper plates having a thickness of 105 µm, pressurized at 120°C under 9 MPa for 30 minutes, heated, and pressurized at 175°C under 9 MPa for 30 minutes, and a composite molded product for measuring a peel strength ratio was obtained. In order to secure the portion to be pulled in the peel test, the copper plate on one side was made longer in a long axis direction than the sheet.

### (Producing of Composite Molded Product for Reflow Test)

A sheet-shaped resin composition was sandwiched between copper plates each having a thickness of 500 and 2,000 µm having surfaces roughened 100 times in advance with a #120 file, pressurized at 120°C under 9 MPa for 30 minutes, heated, and pressurized at 175°C under 9 MPa for 30 minutes to obtain a composite molded product for a reflow test.

The composite molded product obtained above was etched by a predetermined method to pattern the 500 µm copper plate. As for the pattern, a circular pattern having a diameter of 25 mm remained in two parts.

### (Measurement of Thermal Conductivity)

The heat resistance of the resin cured product for measuring the thermal conductivity was measured using "T3ster DynTIM Tester" manufactured by Mentor Graphics. The thermal conductivity was calculated from a relationship between the film thickness of each of the four types of resin cured products and a measured heat resistance value. A probe size at the time of measurement was set to ϕ12.8 mm, a fixed pressure was set to 3400 kPa, and a measurement time was set to 300 sec. In order to increase adhesion between the sample and the probe, "OIL COMPOUND (product name: G-747)" manufactured by Shin-Etsu Chemical Co., Ltd. was used.

### (Measurement and Evaluation of Peel Strength Ratio)

One surface of the composite molded product was fixed to a jig, and a copper plate having a length longer in a long axis direction than the sheet was pulled in a direction perpendicular to the fixed sample at 50 mm/min. In the data obtained as a result, a peel strength a was calculated by calculating an average load in a stable region. In addition, after leaving the same sheet-shaped molded product at room temperature for 1 day before pressurization, a composite molded product was prepared and measured by the same method to calculate a peel strength b, and a peel strength ratio = b/a was calculated. The peel strength was evaluated according to the following criteria.
A: The peel strength ratio was 0.9 or more.
B: The peel strength ratio was less than 0.9.

### (Evaluation by Reflow Test)

The composite molded product for the reflow test was stored in an environment of 85°C and 85% RH for 3 days using a constant temperature and humidity chamber SH-221 (manufactured by ESPEC), then, within 30 minutes, heated from room temperature to 290°C in a nitrogen atmosphere for 12 minutes, held at 290°C for 10 minutes, and cooled to room temperature (hygroscopicity reflow test). After that, an interface between the copper plate and the resin cured product was observed with an ultrasonic imaging device FineSAT (PS300III) (manufactured by Hitachi Power Solutions). The measurement was carried out using a probe having a frequency of 50 MHz, by setting a gain as 30 dB and a pitch as 0.2 mm, and placing the sample in water. It was evaluated according to the following criteria.
A: No interface peeling was observed.
B: Peeling was observed at the interface.

### <Examples 2 and 3 and Comparative Examples 1 to 4>

After obtaining a sheet-shaped resin composition in the same manner as in Example 1 except that each component was used so as to have the composition shown in Table 1, a resin cured product for measuring the thermal conductivity, a composite molded product for measuring the peel strength ratio, and a composite molded product for the reflow test were produced and evaluated.

The results of each example are shown in Table 1.

**[Table 1]**

| | | Example 1 | Example 2 | Example 3 | Comparative Example 1 | Comparative Example 2 | Comparative Example 3 | Comparative Example 4 |
|---|---|---|---|---|---|---|---|---|
| Inorganic filler [% by mass] | Inorganic filler 1 | 217 | 416 | 217 | 93 | 122 | 108 | 93 |
| | Inorganic filler 2 | 81 | 157 | 81 | 473 | 48 | 41 | 473 |
| Thermosetting resin [% by mass] | Resin component 1 | 25 | 48 | 25 | - | 17 | 13 | - |
| | Resin component 2 | - | - | - | 31 | - | - | 31 |
| | Resin component 3 | - | - | - | - | 20 | - | - |
| | Resin component 4 | 20 | 39 | 20 | - | 19 | 10 | - |
| | Resin component 5 | - | - | - | 18 | - | - | 18 |
| | Resin component 6 | - | - | - | 9 | - | - | 9 |
| | Resin component 7 | 41 | 78 | 41 | - | - | 20 | |
| | Resin component 8 | - | - | - | 18 | - | - | 18 |
| Curing agent [% by mass] | Curing agent 1 | 14 | 27 | 14 | 23 | 11 | 7 | 23 |
| Thermosetting catalyst [% by mass] | Thermosetting catalyst 1 | 1 | 1 | 1 | - | 1 | - | 1 |
| | Thermosetting catalyst 2 | 1 | 3 | - | - | - | 1 | - |
| | Thermosetting catalyst 3 | - | - | - | 1 | - | - | 1 |
| | Thermosetting catalyst 4 | | | 1 | | | | |
| Evaluation | Thermal conductivity | 16 | 15 | 15 | 8 | 14 | - | - |
| | Peel strength ratio | A | A | A | B | B | - | B |
| | Reflow test | A | A | A | - | A | B | - |

From the results of the examples, it was found that the obtained resin cured product had high thermal conductivity, since the resin composition of the present invention contains a plurality of thermosetting catalysts. In addition, it was also found that the storage stability of the resin composition was improved, and the adhesion between the metal and the cured product in the reflow test was improved.

### [Industrial Applicability]

According to the resin composition of the present invention, a cured product which has excellent thermal conductivity and adhesion to a metal and which does not easily peel off at an interface when it is compounded with a metal is obtained.

The resin cured product of the present invention has excellent thermal conductivity and adhesion to a metal and does not easily peel off at an interface when it is compounded with a metal.

The composite molded product of the present invention has excellent thermal conductivity and adhesion between a resin cured product and a metal, and does not easily peel off at an interface thereof.

The semiconductor device of the present invention has excellent heat dissipation property and adhesion between a resin cured product and a metal and does not easily peel off at an interface thereof.

## Claims

1. A resin composition comprising:
an inorganic filler;
a thermosetting resin; and
a thermosetting catalyst,
wherein the inorganic filler contains an aggregated inorganic filler,
the thermosetting resin contains an epoxy resin,
the resin composition contains two or more kinds of thermosetting catalysts having a melting point of 100°C or higher, and
two or more kinds of the thermosetting catalysts have a structure derived from imidazole.

2. The resin composition according to Claim 1,
wherein at least one kind of the thermosetting catalysts having the structure derived from imidazole further has a structure derived from triazine in one molecule.

3. The resin composition according to Claim 1 or 2,
wherein the melting point of at least one kind of the thermosetting catalysts is 200°C or higher.

4. The resin composition according to any one of Claims 1 to 3,
wherein the resin composition further contains a solvent optionally, and
a content of the thermosetting catalyst with respect to 100% by mass of the resin composition excluding the inorganic filler and the solvent contained optionally is 0.1 to 10% by mass.

5. The resin composition according to any one of Claims 1 to 4,
wherein a solubility of the thermosetting catalyst in N,N-dimethylformamide at 25°C is 10% by mass or less.

6. The resin composition according to any one of Claims 1 to 5,
wherein the aggregated inorganic filler contains boron nitride aggregated particles.

7. The resin composition according to any one of Claims 1 to 6, further comprising alumina.

8. The resin composition according to any one of Claims 1 to 7,
wherein the aggregated inorganic filler is boron nitride aggregated particles having a card-house structure.

9. The resin composition according to any one of Claims 1 to 8,
wherein a main component of the resin composition is an epoxy resin.

10. A resin cured product formed of the resin composition according to any one of Claims 1 to 9.

11. A composite molded product, comprising:
the resin cured product according to Claim 10; and
a metal.

12. A semiconductor device comprising the composite molded product according to Claim 11.

## Patentansprüche

1. Harzzusammensetzung, umfassend:
einen anorganischen Füllstoff,
ein wärmehärtendes Harz und
einen wärmehärtenden Katalysator,
wobei der anorganische Füllstoff einen aggregierten anorganischen Füllstoff enthält,
das wärmehärtende Harz ein Epoxidharz enthält,
die Harzzusammensetzung zwei oder mehr Arten von wärmehärtenden Katalysatoren mit einem Schmelzpunkt von 100°C oder höher enthält und
zwei oder mehr Arten der wärmehärtenden Katalysatoren eine von Imidazol abgeleitete Struktur aufweisen.

2. Harzzusammensetzung gemäß Anspruch 1,
wobei mindestens eine Art der wärmehärtenden Katalysatoren mit der von Imidazol abgeleiteten Struktur ferner eine von Triazin abgeleitete Struktur in einem Molekül aufweist.

3. Harzzusammensetzung gemäß Anspruch 1 oder 2,
wobei der Schmelzpunkt von mindestens einer Art der wärmehärtenden Katalysatoren 200°C oder höher ist.

4. Harzzusammensetzung gemäß einem der Ansprüche 1 bis 3,
wobei die Harzzusammensetzung ferner optional ein Lösungsmittel enthält und
ein Gehalt des wärmehärtenden Katalysators in Bezug auf 100 Masse-% der Harzzusammensetzung mit Ausnahme des anorganischen Füllstoffs und des optional enthaltenen Lösungsmittels 0,1 bis 10 Masse-% beträgt.

5. Harzzusammensetzung gemäß einem der Ansprüche 1 bis 4,
wobei eine Löslichkeit des wärmehärtenden Katalysators in N,N-Dimethylformamid bei 25°C 10 Masse-% oder weniger beträgt.

6. Harzzusammensetzung gemäß einem der Ansprüche 1 bis 5,
wobei der aggregierte anorganische Füllstoff aggregierte Bornitrid-Partikel enthält.

7. Harzzusammensetzung gemäß einem der Ansprüche 1 bis 6, ferner umfassend Aluminiumoxid.

8. Harzzusammensetzung gemäß einem der Ansprüche 1 bis 7,
wobei der aggregierte anorganische Füllstoff aggregierte Bornitrid-Partikel mit einer Kartenhausstruktur ist.

9. Harzzusammensetzung gemäß einem der Ansprüche 1 bis 8,
wobei eine Hauptkomponente der Harzzusammensetzung ein Epoxidharz ist.

10. Gehärtetes Harzprodukt, das aus der Harzzusammensetzung gemäß einem der Ansprüche 1 bis 9 gebildet ist.

11. Verbundformteil, umfassend:
das gehärtete Harzprodukt gemäß Anspruch 10 und
ein Metall.

12. Halbleiterbauteil, umfassend das Verbundformteil gemäß Anspruch 11.

## Revendications

1. Composition de résine comprenant :
une charge inorganique ;
une résine thermodurcissable ; et
un catalyseur de thermodurcissement,
dans laquelle la charge inorganique contient une charge inorganique agrégée,
la résine thermodurcissable contient une résine époxy,
la composition de résine contient deux types ou plus de catalyseurs de thermodurcissement ayant un point de fusion de 100 °C ou plus, et
deux types ou plus des catalyseurs de thermodurcissement présentent une structure dérivée de l'imidazole.

2. Composition de résine selon la revendication 1,
dans laquelle au moins un type des catalyseurs de thermodurcissement ayant la structure dérivée de l'imidazole présente en outre une structure dérivée de triazine dans une molécule.

3. Composition de résine selon la revendication 1 ou la revendication 2,
dans laquelle le point de fusion d'au moins un type des catalyseurs de thermodurcissement est 200 °C ou plus.

4. Composition de résine selon l'une quelconque des revendications 1 à 3,
dans laquelle la composition de résine contient en outre un solvant facultativement et
une teneur du catalyseur de thermodurcissement par rapport à 100 % en masse de la composition de résine à l'exclusion de la charge inorganique et du solvant contenu facultativement est de 0,1 à 10 % en masse.

5. Composition de résine selon l'une quelconque des revendications 1 à 4,
dans laquelle une solubilité du catalyseur de thermodurcissement dans le N,N-diméthylformamide à 25 °C est de 10 % en masse ou moins.

6. Composition de résine selon l'une quelconque des revendications 1 à 5,
dans laquelle la charge inorganique agrégée contient des particules agrégées de nitrure de bore.

7. Composition de résine selon l'une quelconque des revendications 1 à 6, comprenant en outre de l'alumine.

8. Composition de résine selon l'une quelconque des revendications 1 à 7,
dans laquelle la charge inorganique agrégée est constituée de particules agrégées de nitrure de bore ayant une structure de château de cartes.

9. Composition de résine selon l'une quelconque des revendications 1 à 8,
dans laquelle un composant principal de la composition de résine est une résine époxy.

10. Produit durci de résine formé de la composition de résine selon l'une quelconque des revendications 1 à 9.

11. Produit moulé composite, comprenant :
le produit durci de résine selon la revendication 10 ; et
un métal.

12. Dispositif à semi-conducteur comprenant le produit moulé composite selon la revendication 11.
